# EUROPEAN PATENT SPECIFICATION

(11) **EP 0 784 870 B1**
(45) Date of publication and mention of the grant of the patent: **07.05.2003**
(21) Application number: 95936842.4
(22) Date of filing: 10.10.1995
(51) Int. Cl.: H01L 31/052

(54) **PHOTOVOLTAIC CELL SYSTEM AND AN OPTICAL STRUCTURE THEREFOR**
ANORDNUNG VON PHOTOVOLTAISCHEN ZELLEN UND OPTISCHE STRUKTUR DAFÜR
SYSTEME A CELLULES PHOTOVOLTAIQUES ET STRUCTURE OPTIQUE DESTINEE A UN TEL SYSTEME

(30) Priority: 09.10.1994 IL 11120794
(43) Date of publication of application: 23.07.1997
(73) Proprietor: YEDA RESEARCH AND DEVELOPMENT CO. LTD., Rehovot 76100 (IL)
(72) Inventor: YOGEV, Amnon, 76100 Rehovot (IL)
(74) Representative: Patentanwälte Leinweber & Zimmermann
(86) International application number: US9512368
(87) International publication number: WO96011501

(56) References cited:
- US-A- 4 029 519
- US-A- 4 118 249
- US-A- 4 143 234
- US-A- 4 500 167
- US-A- 4 687 880
- US-A- 4 700 074
- US-A- 4 783 373
- US-A- 4 784 700
- US-A- 4 832 002
- US-A- 4 964 713
- US-A- 5 089 055
- US-A- 5 344 497
- US-A- 5 374 317
- YEHEZKEL N: "LOSSES IN A THREE-DIMENSIONAL COMPOUND PARABOLIC CONCENTRATOR AS A SECOND STAGE OF A SOLAR CONCENTRATOR" SOLAR ENERGY, vol. 51, no. 1, 1 July 1993, pages 45-51, XP000378246
- ARVIZU D E: "PHOTOVOLTAIC CONCENTRATOR RESEARCH PROGRESS*" PHOTOVOLTAIC SPECIALISTS CONFERENCE, LAS VEGAS, OCT. 21 - 25, 1985, vol. VOL. 2, no. CONF. 18, 21 October 1985, INSTITUTE OF ELECTRICAL AND ELECTRONICS ENGINEERS, pages 1529-1536, XP000132141
- B. Todorof, "A 450 suns concentrator module design", 20th IEEE Photovoltaic Specialists Conference, Las Vegas, Nevada, USA, 26.-30. September 1988, The Conference Record of the 20th IEEE Photovoltaic Specialists Conference, IEEE 1988, pages 1347-1352 (XP000167217)

## Description

The present invention relates to a high radiation concentration photovoltaic cell system, and more particularly to an optical structure, constituting light radiation concentrators for photovoltaic cells in combination with a solar radiation collecting and/or reflecting device, forming a photovoltaic cell system.

Solar photovoltaic cells are usually produced as small units, each capable of producing limited electric power in the range of a few watts. For large scale applications, it is necessary to integrate many cells to form a module that can produce higher electric power. Due to mechanical limitations, very close packing of cells is very difficult and in many cases, each cell has a small area with inactive material. When such a module is formed, a portion of the area of the module is inactive and when oriented towards the sun, a fraction of the light that is incident on this area is not utilized. Moreover, when the module is used for converting concentrated solar radiation to electricity, this fraction of concentrated radiation can damage the module.

In cases where a powerful solar radiation source is used, a multitude of solar cells are necessary for the conversion of all available solar radiation light to electric power. A homogenous or stable distribution of light is important for designing parallelly or serially connected cells, since the output of a single module does not provide sufficient current or voltage for large scale systems.

Using non-ideal radiation collecting systems, however, the concentrated solar light at the focal point is not homogeneous and usually it is more concentrated at the center of the radiated beam. The distribution of light within the beam varies with time due to astigmatism and other aberrations of the concentrating devices. Moreover, when selective spectrum illumination is used to excite the cells, very high initial concentration is required. As an example, it can be shown that commercial cells are available that operate efficiently at solar concentrations of 500 suns with efficiency more than 20%. Experiments carried out demonstrated that if only the spectral band between 0.7 and 0.9 micron is used, the efficiency increases to 43%. This spectral band contains only 20% of the incident solar radiation and hence, in order to achieve the same concentration, a concentration factor of 2500 is needed. In order to achieve this concentration, solar radiation tracking systems are necessary when utilizing a dish-like system, a concentration factor of 10000 can be achieved, but in central receiver systems a non-imaging concentrator is needed.

Further, US-A-5,344,497 discloses a radiation concentration photovoltaic cell system comprising an optical structure having a linear array of prismatic concentrators illuminated by radiation concentrated by a linear concentration optics. A photovoltaic cell attaching area of each concentrator of the known system is designed for the attachement of a plurality of photovoltaic cells.

Still further, US-A-4,964,713 discloses a radiation concentration photovoltaic structure having radiation concentrators formed on a common body portion of the structure and arranged in lines so that concentrators of each line have common one-dimensional concentrating sections and individual two-dimensional concentrating sections to be each associated with a single photovoltaic cell.

Still further, US-A-4,700,074 discloses a scintillation camera comprising a scintillation crystal having "teeth" in the form of truncated pyramids on top of a crystal base. The crystal base is suitable for receiving solar radiation.

It is therefore first a broad object of the present invention to ameliorate the disadvantages of the prior art photovoltaic cell modules and to provide an optical structure for mounting a plurality of photovoltaic cells producing substantially total internal reflections.

It is a further broad object of the present invention to provide a photovoltaic cell system combining the optical structure of the present invention with a solar radiation collecting and/or reflecting arrangement.

It is still a further object of the present invention to provide a high radiation concentration, photovoltaic cell system utilizing homogenous collected solar radiation.

In accordance with the present invention, there is therefore provided a high radiation concentration photovoltaic cell system comprising a plurality of photovoltaic cells, at least one optical structure in the form of a three-dimensional body having a first surface facing said photovoltaic cells and a second surface to be, at least indirectly, exposed to light radiation, said body being made of a material at least partially transparent to light and having formed between said surfaces a two-dimensional array of contiguous light radiation concentrators each in the form of an individual prismatic body portion tapering towards said first surface in two dimensions along the entire length of the prismatic body portion, each concentrator defining on said first surface a photovoltaic cell-attaching area aligned with an active portion of a single photovoltaic cell attached thereto, and at least one separate distantly located solar radiation collecting and/or reflecting sun-tracking device arranged to concentrate solar radiation in two dimensions to be impinged on said second surface of the entire array of said optical structure.

The invention further provides a photovoltaic optical structure with a plurality of photovoltaic cells, having a body made of a material at least partially transparent to light and having a first surface facing said photovoltaic cells, and an opposite second surface to be, at least indirectly, exposed to solar radiation; the body of said optical structure having a two-dimensional array of contiguous light radiation prismatic concentrators associated with said first surface and formed on a common body portion associated with said second surface; each radiation concentrator having a length defined between said common body portion and said first surface and tapering towards said first surface in two dimensions all along said length; each radiation concentrator defining at said first surface a photovoltaic cell-attaching area with a single photovoltaic cell attached thereto.

The invention will now be described in connection with certain preferred embodiments with reference to the following illustrative figures so that it may be more fully understood.

With specific reference now to the figures in detail, it is stressed that the particulars shown are by way of example and for purposes of illustrative discussion of the preferred embodiments of the present invention only and are presented in the cause of providing what is believed to be the most useful and readily understood description of the principles and conceptual aspects of the invention. In this regard, no attempt is made to show structural details of the invention in more detail than is necessary for a fundamental understanding of the invention, the description taken with the drawings making apparent to those skilled in the art how the several forms of the invention may be embodied in practice.

In the drawings:
Fig. 1 is an isometric view of an embodiment of an optical structure according to the present invention;
Fig. 2 is a schematic representation of light rays passing through a single concentrator of the optical structure of Fig. 1;
Figs. 3 to 5 are schematic representations of several embodiments of the system according to the present invention, utilizing one or more dish-type solar radiation collecting devices with one or more optical structures;
Figs. 6 to 8 are schematic representations of several other possible embodiments of the present invention, utilizing a plurality,of solar radiation reflectors with the combination of the embodiments shown in Figs. 3 to 5;
Figs. 9 to 10 are schematic representations of two further embodiments of the present invention, utilizing one or more lens-type solar radiation devices with one or more optical structures;
Figs. 11 to 13 are schematic representations respectively corresponding to Figs. 3 to 5, however, with trough-like solar radiation collecting devices, and
Figs. 14 to 17 are schematic representations of still further possible embodiments of the present invention employing light guides.

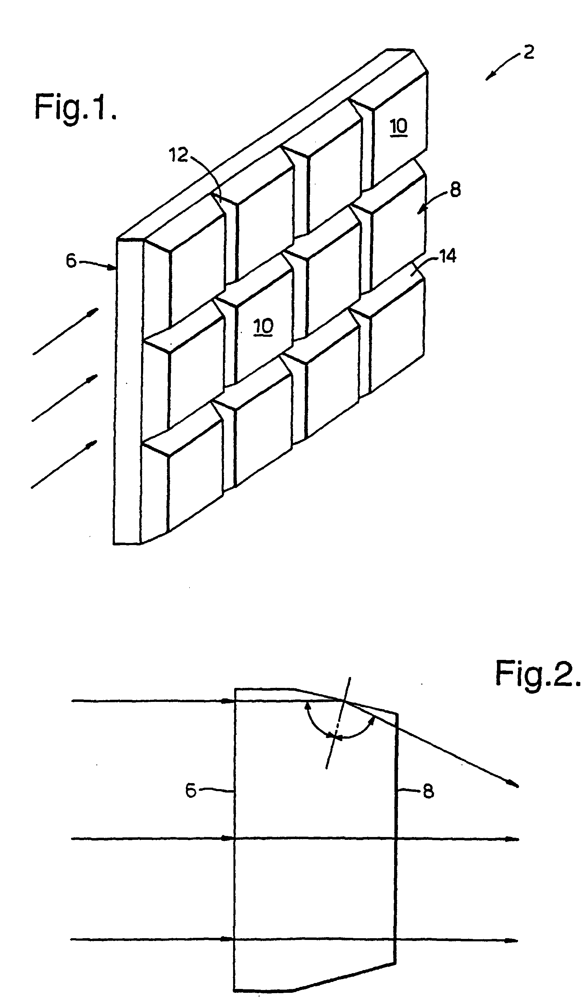

As illustrated in Figs. 1 and 2, the optical structure according to the present invention for mounting a plurality of photovoltaic cells (not shown) is a three-dimensional body 2 made of a material at least partly transparent to light. such material may be glass, glass ceramic, quartz fused silica, sapphire or the like. The body 2 may be configured in any practical shape e.g., prismatic, so as to facilitate eventual juxtapositioning and/or connection to other such bodies. The body 2 has a bottom surface 6 upon which light radiation represented by arrows impinges and an opposite top surface 8 from which the light radiation emerges. On the top surface there is formed an array of cell-attaching active areas 10, constituting non-imaging light radiation concentrators. Each individual cell is placed on the area portion of the concentrators in a way that the light projected onto the surface 6 is due to the geometry of the concentrators, substantially directly propogated and/or totally internally reflected (see Fig. 2) and emerges from the concentrator's surface 8 substantially aligned with the active portion of the photovoltaic cells attached thereto.

One practical manner of achieving such an array of concentrators is to form traversing V-shaped grooves 12,14 defining thereinbetween the areas 10. Naturally, such grooves can be made to follow curved paths or could be circular, so as to define round areas 10, resulting in truncated cones, instead of truncated pyramids shown in Fig. 1. Inversely, the body 2 can be made in such a way as to form trough or dish-shaped concentrators.

The distance between adjacent grooves 12 or 14 and their angular span and thickness should fulfill the following requirements:
a) The narrow part of each individual template of a photovoltaic cell should match the size of the active part of each of the concentrators or solar cells.
b) Most of the light which is incident on the surface 6 of the body 2 will be totally transmitted to the cell by direct propagation or total internal reflection.

At least parts of the body 2 can be coated by selective coatings to enhance transmission or for selective transmission/reflection of different parts of the solar spectrum, to enable selection of the most effective parts of the spectrum for activating the solar cells.

The optical structure hereinbefore described can be incorporated, or be part of, a concentrating system either imaging or non-imaging or part of a complex concentrator made of an assembly of imaging and non-imaging components.

In order to enhance the effectiveness of such photovoltaic optical cell structure, it is proposed to utilize it with a solar radiation collecting and/or reflecting arrangement for directing concentrated solar radiation to be impinged on the optical structure.

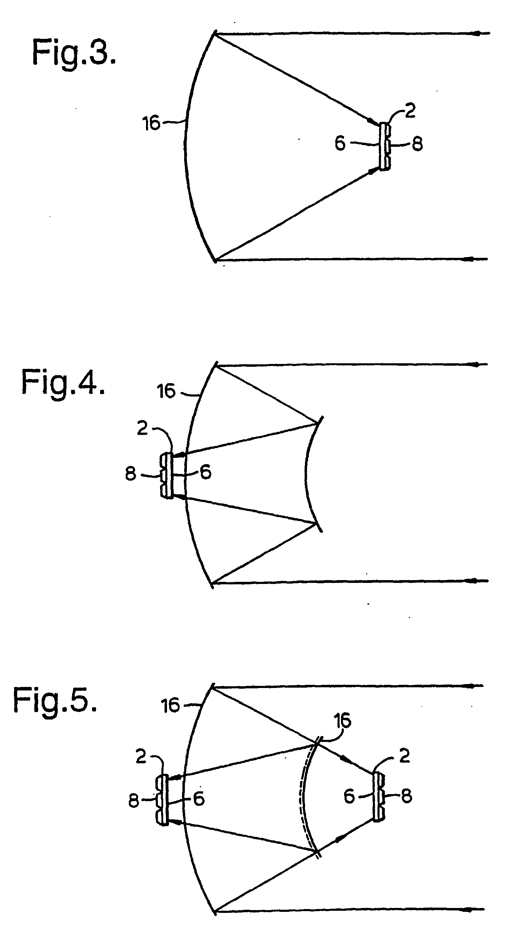

In Figs. 3 to 5 there are illustrated several possible such arrangements utilizing one or more dish-type or parabolic solar radiation collecting or concentrating devices 16. As seen in these figures, the optical body 2 is located on the concave or convexed side of the dish-shaped device 16 with the surface 6 facing the light radiation as directed by the device 16 to be impinged thereon. In Fig. 5, there are shown two bodies 2 arranged to receive solar radiation from two dish-type devices 16.

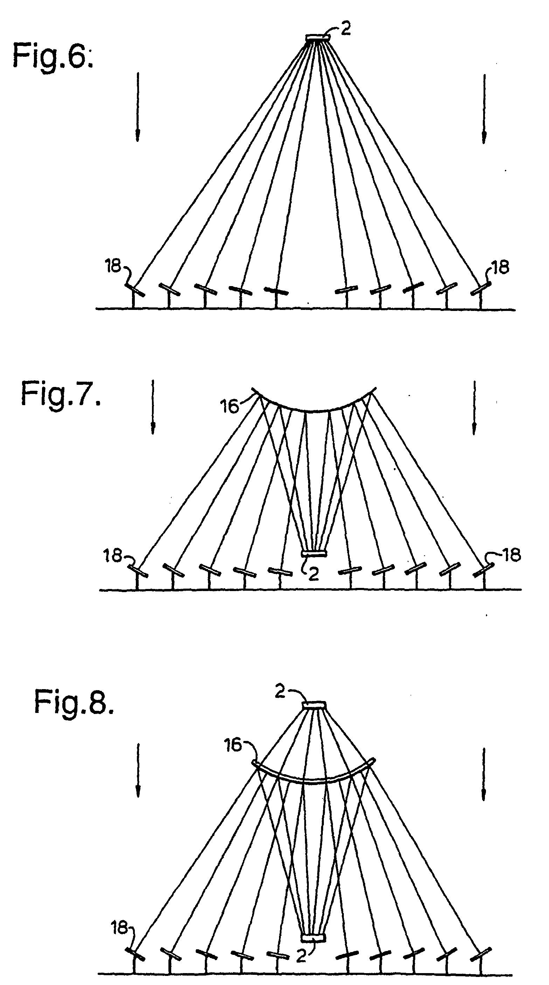

Referring to Fig. 6 there is illustrated a body 2 arranged to receive solar radiation reflected from a multiplicity of devices 18, such as mirrors or other reflecting surfaces. The arrangements shown in Figs. 7 and 8 are similar to those depicted in Figs. 4 and 5, except for the reflecting devices 18 initially collecting the solar radiation and directing same onto the dish-type devices 16.

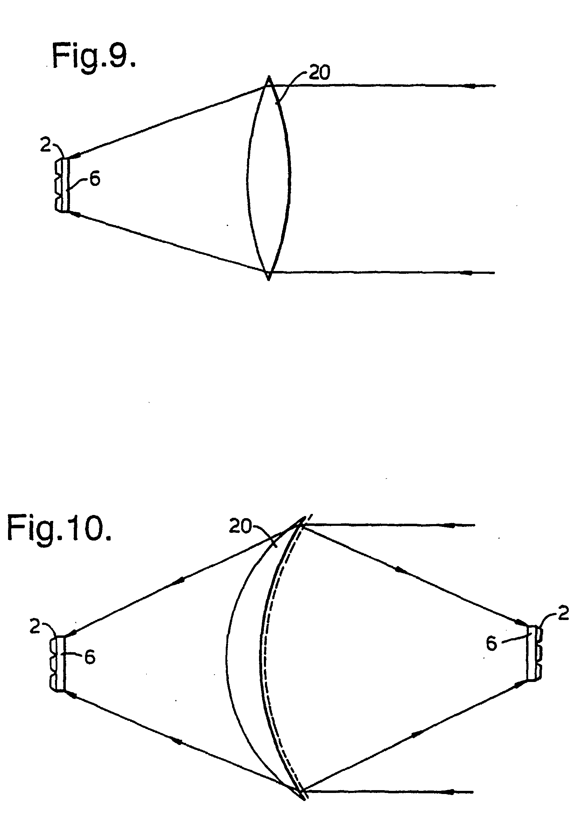

Instead of using dish-type solar concentrating devices 16, lens-type solar concentrating devices 20 having two convex surfaces or one concave and one convexed surface respectively shown in Figs. 9 and 10, can just as well be used.

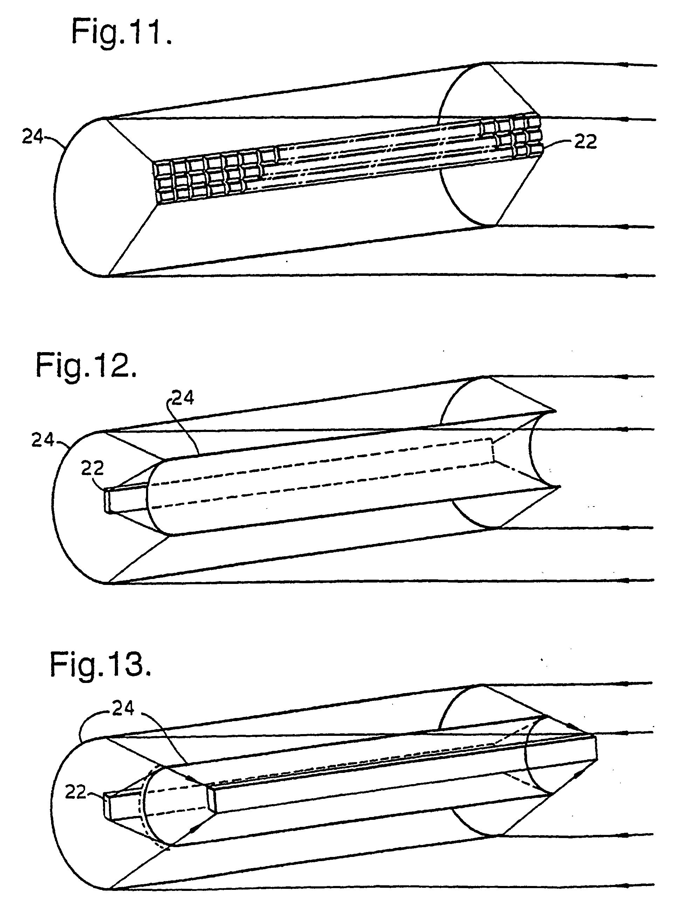

Different configurations of the optical body structure 2 and solar radiation concentrating devices arrangement, is shown in Figs. 11 to 13. Accordingly, the structure of the optical body 22 is in the form of an elongated bar composed of a bank of interconnected smaller bodies 2, arranged to be impinged on one of its surfaces, by solar radiation collected by elongated trough-shaped devices 24.

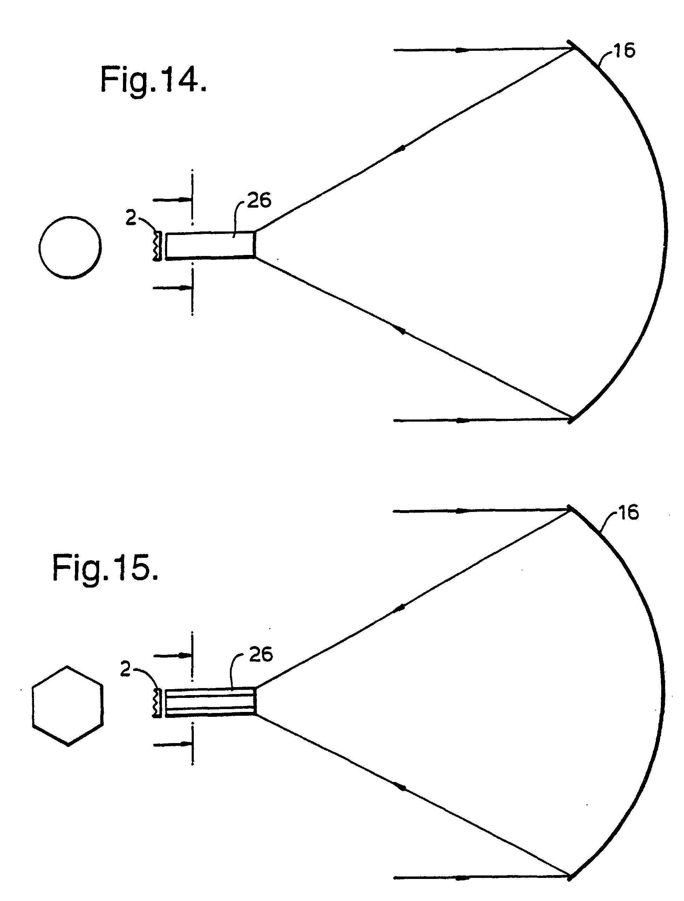

In order to enhance the homogenity of the solar radiation made to impinge on the optical body according to the present invention, a light guide can be coupled to the optical body so that the collected and concentrated light radiation be first passed therethrough to be internally reflected therein prior to impinging on the body, thereby rendering it more homogeneous. Such a light guide 26 can be made of a transparent material and have a circular cross-section as shown in Fig. 14 or a polygonal cross-section, as depicted in Fig. 15.

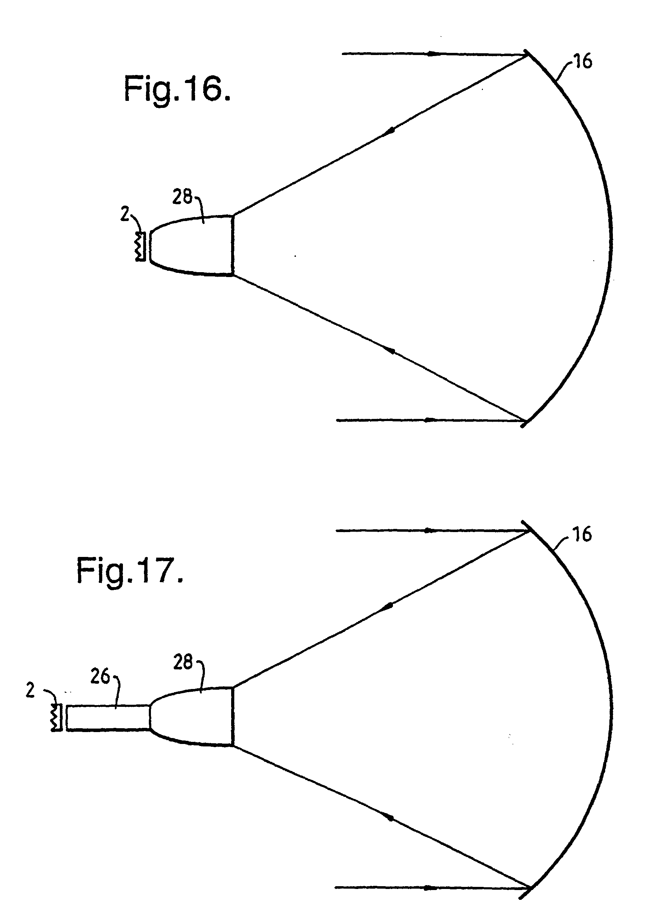

At the entrance of the light guide 26, the light radiation at different locations has different intensities and different directions of propagation. As the light propagates while being reflected internally, the different rays mix and eventually a homogeneous radiation cross section is achieved. The light guide used need not necessarily have a uniform internal cross-section, but could instead be a light converging guide 28, e.g, having conical, internal cross-sections, as shown in Fig. 16. This guide 28 could also be used in combination with a light guide 26 of a uniform internal cross-section, as seen in Fig. 17. When a converging light guide is used, the light is concentrated over a shorter pathway and the homogeneous state will be reached sooner. It should be noted that the concentration power of a conical concentrator is limited and since at each reflection the light is deflected from its original direction, part of the light can be reflected backwards if the concentrator is too long. The conical concentrator can be replaced by another, non-imaging device such as a CPC or CEC. In a central receiver system, the desired concentration cannot be achieved without an intermediate non-imaging device that acts also as a homogenizer.

Finally, as per-se known, further enhancement of the system can be achieved with sun-tracking apparatus controlling the movement of the solar radiation collectors, concentrators or reflectors.

It will be evident to those skilled in the art that the invention is not limited to the details of the foregoing illustrated embodiments and that the present invention may be embodied in other specific forms. The present embodiments are therefore to be considered in all respects as illustrative and not restrictive, the scope of the invention being defined by the appended claims rather than by the foregoing description, and all changes which come within the meaning and range of the claims according to Art. 69 EPC and the protocol on the interpretation thereof are therefore intended to be embraced therein.

## Claims

1. A photovoltaic optical structure with a plurality of photovoltaic cells, said structure having a body (2) made of a material at least partially transparent to light and having a first surface (8) facing said photovoltaic cells, and an opposite second surface (6) to be, at least indirectly, exposed to solar radiation;
the body (2) of said optical structure having a two-dimensional array of contiguous light radiation prismatic concentrators associated with said first surface (8) and formed on a common body portion associated with said second surface (6);
each radiation concentrator having a length defined between said common body portion and said first surface (8) and tapering towards said first surface (8) in two dimensions all along said length;
each radiation concentrator defining at said first surface (8) a photovoltaic cell-attaching area with a single photovoltaic cell attached thereto.

2. The optical structure according to claim 1, wherein each said radiation concentrator is spaced from neighboring concentrators along the entire length and circumference thereof.

3. The optical structure according to claim 1 or 2, wherein said radiation concentrators are formed between mutually perpendicular grooves (12, 14) extending between said first surface (8) and said common body portion and converging towards said common body portion.

4. The optical structure according to any one of the preceding claims wherein said material is one of glass, glass ceramic, quartz fused silica, and sapphire.

5. The optical structure according to any one of the preceding claims, wherein each of said radiation concentrators are configured as a multi-lateral truncated pyramid.

6. The optical structure according to any one of the preceding claims, wherein said body further comprises anti-reflective coating on at least portions of its surfaces.

7. The optical structure according to any one of the preceding claims, further comprising a selective light radiation transmission coating on at least portions of its surfaces.

8. The optical structure according to any one of claims 1 to 7, further comprising an optical element (24, 26, 28) adapted to provide homogeneous distribution of radiation concentrated by said radiation concentrating optics (16, 18, 20, 24), to be impinged on said second surface (6).

9. The optical structure according to any one of claims 1 to 8, wherein said optical element (24, 26, 28) is a light guide at least indirectly coupled to said optical structure.

10. The optical structure according to claim 8, wherein said optical element is a light guide (28) having a converging internal cross-section.

11. A high radiation concentration photovoltaic cell system comprising:
a plurality of photovoltaic cells,
at least one optical structure as claimed in claim 1 and
at least one separate distantly located solar radiation collecting and/or reflecting sun-tracking device (16, 18, 20, 24) arranged to concentrate solar radiation in two dimensions to be impinged on said second surface (6) of the entire array of said optical structure.

12. The system as claimed in claim 11, wherein said material is one of glass, glass ceramic, quartz fused silica and sapphire.

13. The system according to claim 11 or 12, wherein the prismatic body portions of said radiation concentrators are formed on a common body portion (2) of said optical structure.

14. The system according to claim 11, 12 or 13, wherein the radiation concentrators are separated by grooves (12, 14) which are substantially V-shaped.

15. The system according to any one of claims 11 to 14, wherein each prismatic body portion is configured as a multi-lateral truncated pyramid.

16. The system according to any one of claims 11 to 15, wherein said body further comprises an anti-reflective coating on at least portions of its surfaces.

17. The system according to any one of claims 11 to 16, further comprising a selective light radiation transmission coating on at least portions if its surfaces.

18. The system according to any one of claims 11 to 17, wherein said sun-tracking device comprises at least one dish-like surface.

19. The system according to any one of claims 11 to 18, wherein said sun-tracking device comprises a plurality of mirrors (18).

20. The system according to any one of claims 11 to 19, further comprising an optical element (24, 26, 28) adapted to provide homogeneous distribution of radiation concentrated by said radiation concentrating optics, to be impinged on said second surface.

21. The system according to any one of claims 11 to 20, wherein said optical element (24, 26, 28) is a light guide at least indirectly coupled to said optical structure.

22. The system according to claim 21, wherein said optical element (28) is a light guide having a converging internal cross-section.

23. The system according to claim 13, wherein said prismatic body portions are formed in between traversing grooves (12, 14) extending from said first surface (8) to said common portion and converging towards said common portion.

24. The system according to any one of claims 11 to 13, wherein each said radiation concentrator is spaced from neighboring concentrators along the entire length and circumference thereof.

## Patentansprüche

1. Photovoltaische optische Struktur mit einer Mehrzahl photovoltaischer Zellen, welche Struktur einen Körper (2) aus einem zumindest teilweise für Licht transparenten Material und mit einer den photovoltaischen Zellen zugewandten ersten Oberfläche (8) und einer entgegengesetzten zweiten Oberfläche (6) aufweist, die zumindest indirekt Sonnenstrahlung ausgesetzt werden soll;
wobei der Körper (2) der optischen Struktur eine zweidimensionale Anordnung aneinander grenzender prismatischer Lichtstrahlungs-Konzentrations-Einrichtungen aufweist, die mit der ersten Oberfläche (8) verbunden sind und an einem mit der zweiten Oberfläche (6) verbundenen gemeinsamen Körperabschnitt ausgebildet sind;
wobei jede Strahlungs-Konzentrations-Einrichtung eine zwischen dem gemeinsamen Körperabschnitt und der ersten Oberfläche (8) begrenzte Länge aufweist und in Richtung zu der ersten Oberfläche (8) entlang dieser ganzen Länge in zwei Dimensionen schräg zusammenläuft;
und wobei jede Strahlungs-Konzentrations-Einrichtung an der ersten Oberfläche (8) eine Photovoitaikzellen-Befestigungsfläche mit einer einzigen daran befestigten Photovoltaikzelle bildet.

2. Optische Struktur nach Anspruch 1, bei der jede Strahlungs-Konzentrations-Einrichtung von benachbarten Konzentrations-Einrichtungen entlang ihrer gesamten Länge und ihrem gesamten Umfang beabstandet ist.

3. Optische Struktur nach Anspruch 1 oder 2, bei der die Strahlungs-Konzentrations-Einrichtungen zwischen zueinander senkrechten Rillen (12, 14) ausgebildet sind, die sich zwischen der ersten Oberfläche (8) und dem gemeinsamen Körperabschnitt erstrecken und in Richtung zu dem gemeinsamen Körperabschnitt konvergieren.

4. Optische Struktur nach einem der vorstehenden Ansprüche, bei der das Material Glas, Glaskeramik, Quarzglas oder Saphir ist.

5. Optische Struktur nach einem der vorstehenden Ansprüche, bei der sämtliche Strahlungs-Konzentrations-Einrichtungen als vielseitige Stumpfpyramiden konfiguriert sind.

6. Optische Struktur nach einem der vorstehenden Ansprüche, bei der der Körper ferner eine Antireflexionsbeschichtung auf zumindest Teilen seiner Oberflächen aufweist.

7. Optische Struktur nach einem der vorstehenden Ansprüche, ferner mit einer selektiven Lichttransmissionsbeschichtung auf zumindest Teilen ihrer Oberflächen.

8. Optische Struktur nach einem der Ansprüche 1 - 7, ferner mit einem optischen Element (24, 26, 28), das dazu ausgelegt ist, eine homogene Verteilung von durch die Strahlungs-Konzentrations-Optik (16, 18, 20, 24) konzentrierter Strahlung zu erzeugen, um diese auf die zweite Oberfläche (6) treffen zu lassen.

9. Optische Struktur nach einem der Ansprüche 1 - 8, bei der das optische Element (24, 26, 28) ein zumindest indirekt mit der optischen Struktur gekoppelter Lichtleiter ist.

10. Optische Struktur nach Anspruch 8, bei der das optische Element ein Lichtleiter (28) mit einem konvergierenden inneren Querschnitt ist.

11. Photovoltaisches Zellensystem mit hoher Strahlungskonzentration, das aufweist:
eine Mehrzahl photovoltaischer Zellen,
zumindest eine optische Struktur nach Anspruch 1 und
zumindest eine entfernt angeordnete Sonnenstrahlung sammelnde und/oder reflektierende Sonnennachfahrvorrichtung (16, 18, 20, 24), die dazu ausgelegt ist, Sonnenstrahlung in zwei Dimensionen zu konzentrieren und diese auf die zweite Oberfläche (6) der gesamten Anordnung der optischen Struktur treffen zu lassen.

12. System nach Anspruch 11, bei dem das Material Glas, Glaskeramik, Quarzglas oder Saphir ist.

13. System nach Anspruch 11 oder 12, bei dem die prismatischen Körperabschnitte der Strahlungs-Konzentrations-Einrichtungen an einem gemeinsamen Körperabschnitt (2) der optischen Struktur ausgebildet sind.

14. System nach Anspruch 11, 12 oder 13, bei dem die Strahlungs-Konzentrations-Einrichtungen durch Rillen (12, 14) getrennt sind, die im Wesentlichen V-förmig sind.

15. System nach einem der Ansprüche 11 - 14, bei dem jeder prismatische Körperabschnitt als vielseitige Stumpfpyramide konfiguriert ist.

16. System nach einem der Ansprüche 11 - 15, bei dem der Körper ferner eine Antireflexionsbeschichtung auf zumindest Teilen seiner Oberflächen aufweist.

17. System nach einem der Ansprüche 11 - 16, ferner mit einer selektiven Lichttransmissionsbeschichtung auf zumindest Teilen seiner Oberflächen.

18. System nach einem der Ansprüche 11 - 17, bei dem die Sonnennachfahrvorrichtung zumindest eine schüsselartige Oberfläche aufweist.

19. System nach einem der Ansprüche 11 - 18, bei dem die Sonnennachfahrvorrichtung eine Mehrzahl Spiegel (18) aufweist.

20. System nach einem der Ansprüche 11 - 19, ferner mit einem optischen Element (24, 26, 28), das dazu ausgelegt ist, eine homogene Verteilung von durch die Strahlungs-Konzentrations-Optik konzentrierter Strahlung zu erzeugen, um diese auf die zweite Oberfläche treffen zu lassen.

21. System nach einem der Ansprüche 11 - 20, bei dem das optische Element (24, 26, 28) ein zumindest indirekt mit der optischen Struktur gekoppelter Lichtleiter ist.

22. System nach Anspruch 21, bei dem das optische Element ein Lichtleiter (28) mit einem konvergierenden inneren Querschnitt ist.

23. System nach Anspruch 13, bei dem die prismatischen Körperabschnitte zwischen sich von der ersten Oberfläche (8) zu dem gemeinsamen Abschnitt erstreckenden und in Richtung zu dem gemeinsamen Abschnitt konvergierenden Querrillen (12, 14) gebildet sind.

24. System nach einem der Ansprüche 11 - 13, bei dem jede Strahlungs-Konzentrations-Einrichtung von benachbarten Konzentrations-Einrichtungen entlang ihrer gesamten Länge und ihrem gesamten Umfang beabstandet ist.

## Revendications

1. Structure optique photovoltaïque avec une pluralité de cellules photovoltaïques, ladite structure ayant un corps (2) formé d'une matière au moins partiellement transparente à la lumière et ayant une première surface (8) faisant face auxdites cellules photovoltaïques, et une seconde surface, opposée (6), destinée à être exposée, au moins indirectement, au rayonnement solaire ;
le corps (2) de ladite structure optique ayant un réseau à deux dimensions de concentrateurs prismatiques contigus de rayonnement lumineux associés à ladite première surface (8) et formés sur une partie commune de corps associée à ladite seconde surface (6) ;
chaque concentrateur de rayonnement ayant une longueur définie entre ladite partie commune de corps et ladite première surface et s'effilant vers ladite première surface (8) dans deux dimensions sur toute ladite longueur ;
chaque concentrateur de rayonnement définissant à ladite première surface (8) une zone de fixation de cellule photovoltaïque à laquelle une seule cellule photovoltaïque est fixée.

2. Structure optique selon la revendication 1, dans laquelle chaque concentrateur de rayonnement est espacé de concentrateurs voisins sur toute sa longueur et sur toute sa circonférence.

3. Structure optique selon la revendication 1 ou 2, dans laquelle lesdits concentrateurs de rayonnement sont formés entre des gorges mutuellement perpendiculaires (12, 14) s'étendant entre ladite première surface (8) et ladite partie commune de corps et convergeant vers ladite partie commune de corps.

4. Structure optique selon l'une quelconque des revendications précédentes, dans laquelle ladite matière est du verre, une céramique de verre, de la silice de quartz fondue ou du saphir.

5. Structure optique selon l'une quelconque des revendications précédentes, dans laquelle chacun desdits concentrateurs de rayonnement est configuré en une pyramide multilatérale tronquée.

6. Structure optique selon l'une quelconque des revendications précédentes, dans laquelle ledit corps comporte en outre un revêtement anti-réfléchissant sur au moins des parties de ses surfaces.

7. Structure optique selon l'une quelconque des revendications précédentes, comportant en outre un revêtement sélectif de transmission de rayonnement lumineux sur au moins des parties de ses surfaces.

8. Structure optique selon l'une quelconque des revendications 1 à 7, comportant en outre un élément optique (24, 26, 28) conçu pour réaliser une distribution homogène d'un rayonnement concentré par ladite optique (16, 18, 20, 24) de concentration de rayonnement, afin qu'il tombe sur ladite seconde surface (6).

9. Structure optique selon l'une quelconque des revendications 1 à 8, dans laquelle ledit élément optique (24, 26, 28) est un guide de lumière couplé au moins indirectement à ladite structure optique.

10. Structure optique selon la revendication 8, dans laquelle ledit élément optique est un guide de lumière (28) ayant une section transversale interne convergente.

11. Système de cellules photovoltaïques à haute concentration de rayonnement comportant :
plusieurs cellules photovoltaïques,
au moins une structure optique selon la revendication 1, et
au moins un dispositif (16, 18, 20, 24) de poursuite du soleil collectant et/ou réfléchissant le rayonnement solaire, séparé et placé à distance, agencé de façon à concentrer le rayonnement solaire dans deux dimensions afin qu'il tombe sur ladite seconde surface (6) du réseau entier de ladite structure optique.

12. Système selon la revendication 11, dans lequel ladite matière est du verre, une céramique de verre, de la silice de quartz fondue ou du saphir.

13. Système selon la revendication 11 ou 12, dans lequel les parties de corps prismatiques desdits concentrateurs de rayonnement sont formées sur une partie commune (2) de corps de ladite structure optique.

14. Système selon la revendication 11, 12 ou 13, dans lequel les concentrateurs de rayonnement sont séparés par des gorges (12, 14) qui sont sensiblement en forme de "V".

15. Système selon l'une quelconque des revendications 11 à 14, dans lequel chaque partie de corps prismatique est configurée sous la forme d'une pyramide multilatérale tronquée.

16. Système selon l'une quelconque des revendications 11 à 15, dans lequel ledit corps comporte en outre un revêtement anti-réfléchissant sur au moins des parties de ses surfaces.

17. Système selon l'une quelconque des revendications 11 à 16, comportant en outre un revêtement sélectif transmettant le rayonnement lumineux sur au moins des parties de ses surfaces.

18. Système selon l'une quelconque des revendications 11 à 17, dans lequel ledit dispositif de poursuite du soleil comporte au moins une surface analogue à une cuvette.

19. Système selon l'une quelconque des revendications 11 à 18, dans lequel ledit dispositif de poursuite du soleil comporte plusieurs miroirs (18).

20. Système selon l'une quelconque des revendications 11 à 19, comportant en outre un élément optique (24, 26, 28) conçu pour produire une distribution homogène du rayonnement concentré par ladite optique de concentration de rayonnement, afin qu'il tombe sur ladite seconde surface.

21. Système selon l'une quelconque des revendications 11 à 20, dans lequel ledit élément optique (24, 26, 28) est un guide de lumière couplé au moins indirectement à ladite structure optique.

22. Système selon la revendication 21, dans lequel ledit élément optique est un guide de lumière ayant une section transversale interne convergente.

23. Système selon la revendication 13, dans lequel lesdites parties de corps prismatiques sont formées entre des gorges traversantes (12, 14) s'étendant de ladite première surface (8) jusqu'à ladite partie commune et convergeant vers ladite partie commune.

24. Système selon l'une quelconque des revendications 11 à 13, dans lequel chaque concentrateur de rayonnement est espacé de concentrateurs voisins sur toute sa longueur et toute sa circonférence.
